# FASCICULE DE BREVET EUROPEEN

(11) **EP 4 507 965 B1**
(45) Date de publication et mention de la délivrance du brevet: **03.06.2026**
(21) Numéro de dépôt: 23714802.8
(22) Date de dépôt: 14.03.2023
(51) Int. Cl.: B64G 1/00, B64G 1/62

(54) **PROCÉDÉ DE SÉLÉCTION DE CAS DE CHARGES PAR RÉDUCTION DE DIMENSIONNALITÉ POUR LE DIMENSIONNEMENT D'UN SYSTÈME LANCEUR SPATIAL RÉUTILISABLE**
VERFAHREN ZUR AUSWAHL VON LASTFÄLLEN DURCH DIMENSIONALITÄTSREDUKTION ZUR DIMENSIONIERUNG EINES WIEDERVERWENDBAREN RAUMSTARTSYSTEMS
METHOD FOR SELECTING LOAD CASES BY DIMENSIONALITY REDUCTION FOR DIMENSIONING A REUSABLE SPACE LAUNCHER SYSTEM

(30) Priorité: 14.04.2022 FR 2203477
(43) Date de publication de la demande: 19.02.2025
(73) Titulaire: Centre National d'Études Spatiales, 75039 Paris Cedex 01 (FR)
(72) Inventeur: GARCIA MARTINEZ, Adrian, 78500 SARTROUVILLE (FR)
(74) Mandataire: Germain Maureau
(86) Numéro de dépôt international: PCT/FR2023/050344
(87) Numéro de publication internationale: WO 2023/198972

(56) Documents cités:
- CN-B- 106 951 589
- CN-B- 107 169 209
- US-B1- 8 725 470
- PHILIPP M FISCHER ET AL: "A formal method for early spacecraft design verification", AEROSPACE CONFERENCE, 2013 IEEE, IEEE, 2 March 2013 (2013-03-02), pages 1 - 8, XP032397014, ISBN: 978-1-4673-1812-9, DOI: 10.1109/AERO.2013.6496878
- CALVI ET AL: "Uncertainty-based loads analysis for spacecraft: Finite element model validation and dynamic responses", COMPUTERS AND STRUCTURES, PERGAMON PRESS, GB, vol. 83, no. 14, 1 May 2005 (2005-05-01), pages 1103 - 1112, XP027637041, ISSN: 0045-7949, [retrieved on 20050501]

## Description

La présente invention concerne le domaine du dimensionnement d'un système lanceur spatial, et en particulier d'un système lanceur spatial réutilisable.

Conventionnellement, un système lanceur spatial, dit lanceur spatial, ou lanceur, comprend un ou plusieurs étages. Un étage comprend un ou plusieurs modules. Un module comprend une structure mécanique nue, dite structure, et des équipements, ou composants, par exemple des pieds d'atterrissage. Une structure nue comprend un ensemble de sous-structures. Chaque sous-structure comprend une ou plusieurs zones. Chaque zone est associée à une épaisseur de la zone.

Un cas de charge étant défini comme une combinaison d'efforts subis par une structure, il est connu d'utiliser l'ensemble de tous les cas de charges possibles pour dimensionner un lanceur appelé à subir potentiellement ces différentes combinaisons d'effort pendant l'utilisation du lanceur. Le nombre de cas de charges à considérer pour le dimensionnement d'un lanceur spatial a augmenté considérablement pour répondre aux besoins de réutilisation desdits lanceurs ; notamment, le contrôle d'attitude pour l'atterrissage des étages d'un lanceur se traduit par des efforts locaux au niveau des aérogouvernes, qui doivent être pris en compte pour le dimensionnement des lanceurs réutilisables; de même, les pieds d'atterrissages génèrent des efforts locaux au niveau de la structure à laquelle lesdits pieds sont attachés. Il est donc nécessaire de réduire autant que possible le nombre des cas de charges à prendre en compte pour effectuer le dimensionnement des structures futures, notamment celles des lanceurs spatiaux réutilisables.

L'invention a donc pour but de proposer une solution à tout ou partie de ces problèmes.

A cet effet, la présente invention concerne un procédé mis en œuvre par ordinateur pour le dimensionnement d'un lanceur spatial, le lanceur spatial comprenant au moins un module, l'au moins un module comprenant une structure, le procédé comprenant les étapes suivantes:
- détermination d'un ensemble des cas de charge à prendre en compte pour dimensionner l'au moins un module du lanceur, un cas de charge étant défini comme une combinaison des composantes d'efforts mécaniques qui s'appliquent en même temps à la structure de l'au moins un module, chaque combinaison comprenant un nombre N de composantes d'efforts mécaniques, l'ensemble des cas de charge étant ainsi défini dans un espace de dimension;
- projection de l'ensemble dans un hyperplan de dimension n, n étant inférieur à N;
- détermination d'une enveloppe de la projection dans l'hyperplan, ladite enveloppe définissant un sous-ensemble de cas de charge ;
- utilisation du sous-ensemble de cas de charge pour dimensionner l'au moins un module.

Selon ces dispositions, on obtient un sous-ensemble comprenant un nombre de cas de charge inférieur, voire très inférieur, au nombre de cas de charge de l'ensemble.

Selon un mode de mise en œuvre, l'invention comprend une ou plusieurs des caractéristiques suivantes, seules ou en combinaison techniquement acceptable. Selon un mode de mise en œuvre, l'hyperplan est déterminé par une analyse en composantes principales de l'ensemble des cas de charges.

Selon un mode de mise en œuvre, un effort mécanique est un effort général et/ou un effort local.

Selon un mode de mise en œuvre, un effort local est un effort mécanique qui s'applique à une interface de la structure, ou à une sous-structure de la structure, de l'au moins un module du lanceur spatial avec un composant externe à la structure de l'au moins un module, l'effort local comprenant au moins une composante de l'effort local.

Selon un mode de mise en œuvre, le composant externe comprend au moins l'un parmi: un ou plusieurs pieds d'atterrissage, un ou plusieurs moteurs, une ou plusieurs aérogouvernes.

Selon un mode de mise en œuvre, le lanceur spatial comprend au moins deux modules du lanceur spatial, un effort général étant un effort mécanique qui s'applique à une section d'interface entre un module du lanceur spatial et un autre module du lanceur spatial, ledit effort général comprenant au moins une composante de l'effort général.

Selon un mode de mise en œuvre, l'effort général est généré par les flux aérothermiques et l'environnement vibratoire de la structure.

Selon un mode de mise en œuvre, le dimensionnement de la structure comprenant la détermination d'une masse du lanceur en fonction de critères de dimensionnement.

Selon un mode de mise en œuvre, les critères de dimensionement comprennent des critères de tenue mécanique, de stabilité mécanique, et des critères fonctionnels.

Selon un mode de mise en œuvre la détermination d'une masse du lanceur comprend la détermination d'une valeur minimum de la masse.

Selon un mode de mise en œuvre, la détermination d'une masse du lanceur comprend la détermination d'une masse de l'au moins un module du lanceur, la détermination d'une masse de l'au moins un module comprenant la détermination d'une épaisseur d'une sous structure de la structure de l'au moins un module en fonction des critères de dimensionnement appliqués à la structure.

Selon un mode de mise en œuvre, le lanceur spatial comprend une pluralité de modules et la structure de chaque module comprend une pluralité de sous-tructure, l'épaisseur de chaque sous-structure de la structure de chaque module de la pluralité de modules étant déterminée de sorte qu'une somme des masses de chaque module soit minimum.

Pour sa bonne compréhension, un mode de réalisation et/ou de mise en oeuvre de l'invention est décrit en référence aux dessins ci-annexés représentant, à titre d'exemple non limitatif, une forme de réalisation ou de mise en œuvre respectivement d'un dispositif et/ou d'un procédé selon l'invention. Les mêmes références sur les dessins désignent des éléments similaires ou des éléments dont les fonctions sont similaires.
[Fig. 1] est une représentation simplifiée d'un lanceur spatial constitué d'un certain nombre de modules.
[Fig. 2] est une représentation simplifiée d'un module d'un lanceur spatial.
[Fig. 3] est une représentation simplifiée d'une interface entre un pied d'atterrissage et la structure d'un module d'un lanceur spatial
[Fig. 4] est une représentation graphique d'une évolution en fonction du temps d'une composante d'un effort correspondant à un cas de charge.
[Fig. 5] est une représentation graphique d'un ensemble des combinaisons possibles de deux composantes, chaque combinaison étant obtenue en considérant les différentes valeurs que chaque composante est susceptible de prendre en fonction du temps selon un scénario particulier d'évolution.
[Fig. 6] est une représentation graphique d'un ensemble des combinaisons possibles de trois composantes dans un espace à 3 dimensions, chaque combinaison étant obtenue en considérant les différentes valeurs que chaque composante est susceptible de prendre en fonction du temps selon un scénario particulier d'évolution.
[Fig. 7] est une représentation graphique d'une projection sur un plan, espace à deux dimensions, des différentes combinaisons possibles de trois composantes définies dans l'espace à 3 dimensions.
[Fig. 8] est un organigramme séquentiel des étapes du procédé selon l'invention.

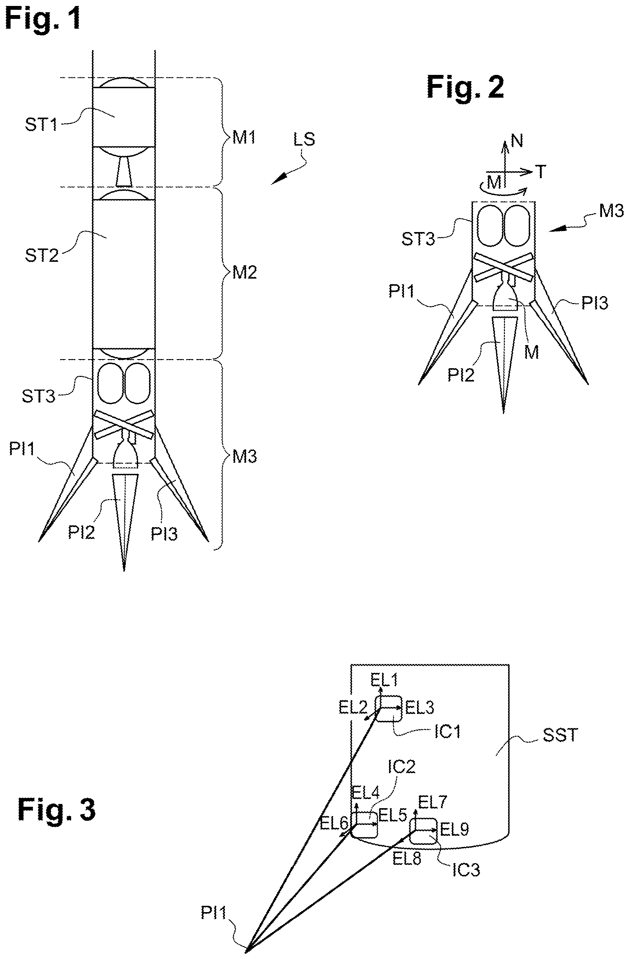

La figure 1 représente, de manière simplifiée, un exemple de structure d'un lanceur spatial LS. La structure comprend classiquement plusieurs modules M1, M2, M3 ; comme cela est illustré pour le module M3 sur les figures 2 et 3, chaque module M1, M2, M3 comprend typiquement une structure mécanique nue, ou structure ST1, ST2, ST3, équipée ; ladite structure ST1, ST2, ST3 peut être divisée en sous structures SST. L'interface entre un module M1, M2, M3 et un autre module M1, M2, M3 est appelée section d'interface IS ; un module M1, M2, M3 peut comprendre, en plus de cette interface, d'autres interfaces IC1, IC2, IC3 entre sa structure ST1, ST2, ST3 et des composants externes rattachés à la structure ST1, ST2, ST3 ou à une sous-structure SST d'une structure ST1, ST2, ST3 dudit module M1, M2, M3. Ainsi, un composant externe au module M3 est, par exemple, un pied d'atterrissage PI1, PI2, PI3 ; comme cela est illustré sur la figure 3 à titre d'exemple, la sous-structure SST de la structure ST3 du module M3 a trois interfaces IC1, IC2, IC3, comprenant respectivement par exemple trois ferrures d'attache, avec le pied PI1. Un autre exemple de composant externe à un module M1, M2, M3 est un moteur M, ou une aérogouverne.

Au cours d'une mission du lanceur spatial LS, le lanceur est soumis à une combinaison d'efforts mécaniques qui s'appliquent à la structure ST1, ST2, ST3 des différents modules M1, M2, M3 sous l'effet des flux aérothermiques et de l'environnement vibratoire du lanceur LS. On distingue classiquement d'une part les efforts généraux, conséquences de l'environnement aérodynamique et vibratoire du lanceur LS, et les effort locaux.

Les efforts généraux sont conventionnellement définis par les composantes d'un torseur d'effort, M, N, T, correspondant à un Moment de flexion M, un Effort Normal N, et un Effort Tangentiel T, représentés à titre d'exemple sur la figure 2; les efforts généraux s'appliquent sur la section d'interface IS entre chaque module M1, M2, M3 du lanceur, comme cela est illustré sur la figure 2 à titre d'exemple sur une section d'interface IS entre le module M3 et le module M2.

Les efforts locaux sont générés par les composants externes à chaque module M1, M2, M3 ; les efforts locaux sont conventionnellement définis par les composantes qui s'appliquent sur la sous structure SST à laquelle ils sont attachés dans chaque module M1, M2, M3 du lanceur, aux interfaces de chaque composant externe PI1, PI2, PI3, M avec la sous-structure SST de la structure ST dudit module M1, M2, M3. Ainsi, par exemple, les efforts locaux générés par le pied d'atterrissage PI1 aux interfaces IC1, IC2, IC3 du pied PI1 avec la sous structure du module M3, comprennent respectivement les composantes EL1, EL2, EL3, qui s'appliquent à la première interface IC1 du pied PI1 avec la sous structure SST de la structure ST3 du module M3 du lanceur LS, et EL4, EL5, EL6, qui s'appliquent à une deuxième interface IC2, et EL7, EL8, EL9, qui s'appliquent à une troisième interface IC3.

Ainsi à chaque instant de la mission du lanceur spatial, la structure est soumise à une combinaison d'efforts mécaniques comprenant les différentes composantes M, N, T des efforts généraux, et les différentes composantes EL1, EL2, EL3, EL4, EL5, EL6, EL7, EL8, EL9 des efforts locaux, ces différentes composantes s'appliquant chacune en une ou plusieurs sous-structures SST des structures respectives ST1, ST2, ST3 des différents modules M1, M2, M3 du lanceur LS.

Les efforts généraux qui s'appliquent à un instant t sur le module arrière M3 du lanceur LS comprennent jusqu'à 6 composantes, qui sont ramenées en pratique le plus souvent aux trois composantes M, N, T, représentées sur la figure 2; Ainsi en considérant par exemple les trois composantes M, N, T d'un effort général qui s'applique une interface IS de la structure ST3 du module arrière M3 du lanceur LS, et en considérant les neuf composantes EL1, EL2, EL3, EL4, EL5, EL6, EL7, EL8, EL9 des efforts locaux qui s'appliquent simultanément sur le module arrière M3 aux interfaces IC1, IC2, IC3 de chaque pied PI1, PI2, PI3, avec la sous-structure SST de la structure ST3 du module arrière M3, soit pour 4 pieds 36 composantes d'efforts (3 pieds seulement sont représentés sur la figure 2 pour simplifier la figure 2), et en considérant une composante pour un effort local de poussée moteur qui s'applique à une interface entre le moteur M et une autre sous structure du module arrière M3 du lanceur LS, la combinaison des efforts mécaniques, i.e. le cas de charge, qui s'applique sur le module arrière M3 à un instant t d'un atterrissage du lanceur LS comprend donc 43 composantes, autrement dit 43 chargements unitaires.

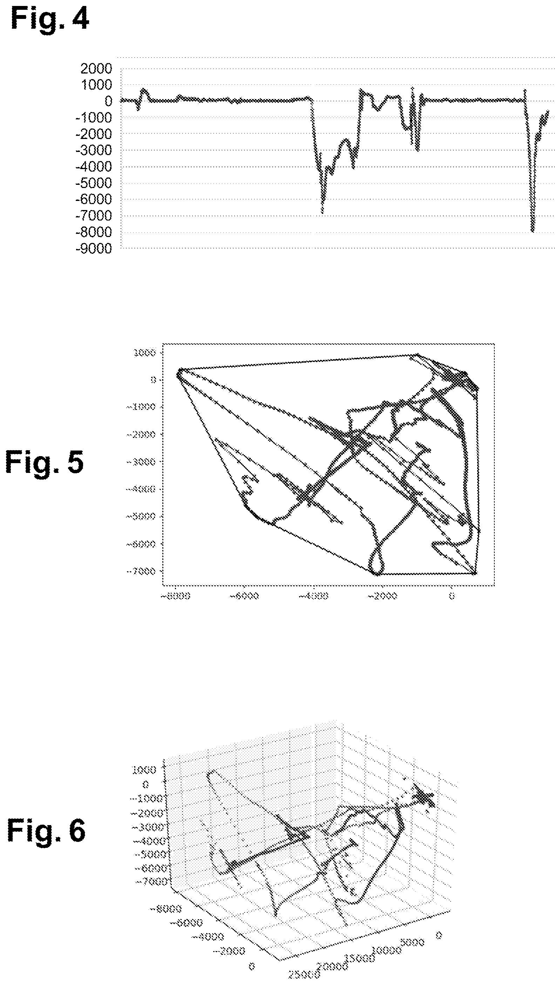

Des simulations système d'une phase d'atterrissage sont effectuées en envisageant tous les scénarios possibles en fonction de la dispersion des paramètres de mission (e.g. atterrissage sur deux pieds, trois ou quatre). Chaque scénario présente une répartition de réactions au sol différente qui se traduit sous forme d'une variabilité importante au niveau des efforts locaux d'interface aux ferrures. La combinatoire de toutes ces sources de sollicitation mécaniques possibles conduit à un très grand nombre de cas de charge. Chaque composante , ou chargement simple, est susceptible de prendre au cours du temps un ensemble de valeurs, qui sont représentées à titre d'exemple en ordonnée sur le graphique de la figure 4; sur la figure 5 sont représentées dans un espace à deux dimensions les différentes combinaisons, ou cas de charges, à deux composantes que l'on obtient en considérant toutes les valeurs d'une première composante susceptibles d'être combinées, ou associées, à chacune des valeurs susceptibles d'être prises par une deuxième composante en combinaison avec une valeur de la première composante ; sur la figure 6 sont représentées dans un espace à trois dimensions les différentes combinaisons , ou cas de charges, à trois composantes que l'on obtient de manière similaire. Ainsi, en reprenant l'exemple considéré ci-dessus, et en combinant les différentes valeurs que sont susceptibles de prendre les 43 composantes, on peut arriver à environ 7 millions de combinaisons, ou de cas de charges possibles.

Le dimensionnement mécanique des structures ST1, ST2, ST3 respectives de chaque module M1, M2, M3 consiste en une minimisation de la masse desdites structures ST1, ST2, ST3, tout en respectant les critères de dimensionnement pertinents (i.e. critères de tenue, de stabilité et critères fonctionnels). La minimisation de la masse d'une structure correspond, par exemple, à une minimisation d'une épaisseur des différentes sous structures de ladite structure, pour chaque module M1, M2, M3 du lanceur LS. Les critères de dimensionnement sont évalués pour tous les cas de charges potentiellement critiques pour le module M1, M2, M3 considéré, cependant, il n'est pas possible de prendre tous les cas de charges en compte pour des raisons de coût et de temps de simulation. Il est donc nécessaire de faire une sélection d'un sous-ensemble de cas de charges dimensionnants. L'objectif est de retirer les CDC qui n'apportent aucune, ou peu de, plus-value car couverts par d'autres CDC plus critiques vis-à-vis des critères de dimensionnement. Il est difficile d'identifier les CDC dimensionnants sans tous les évaluer. A priori, dans des structures complexes, nous ne pouvons pas savoir quelle combinaison de sollicitations ponctuelles entraîne une marge faible vis-à-vis des critères de dimensionnement. Il est proposé ici une stratégie très particulière pour minimiser le besoin d'évaluation de cas de charges : la réduction de dimensionnalité.

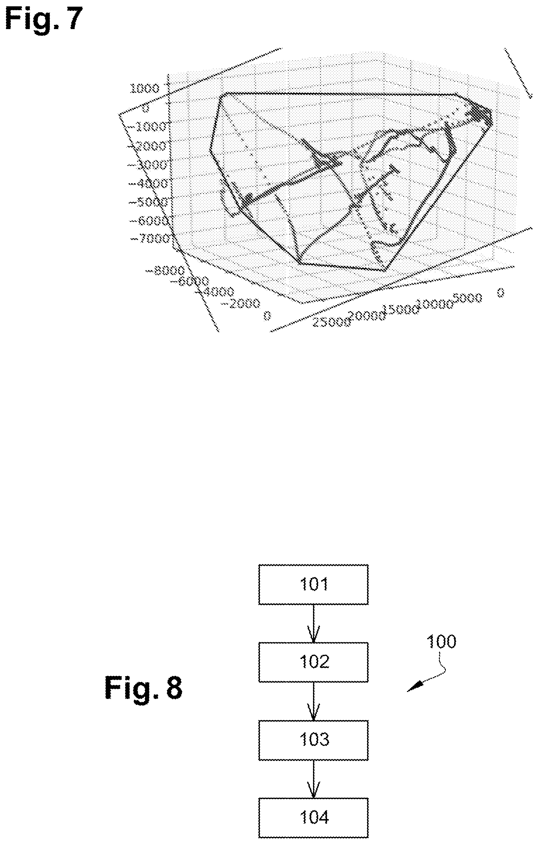

Ainsi, sur la figure 7, est illustré le principe de la méthode appliqué au cas d'un ensemble de combinaisons, ou de cas de charges, à trois composantes, i.e. dans un espace à trois dimensions. L'ensemble des combinaisons, ou cas de charges, de l'espace à 3 dimensions est projeté sur un plan déterminé par analyse en composante principale de l'ensemble des combinaisons ; dans ce plan, une enveloppe de l'ensemble des points projetés forme un sous ensemble de cas de charges de dimension réduite par rapport à l'ensemble initial des combinaisons dans l'espace à trois dimensions.

Par analogie, en considérant un ensemble de cas de charges comprenant plusieurs dizaines de composantes, donc plusieurs millions de cas de charges dans un espace à plusieurs dizaines de dimension, une analyse en composante principale de l'ensemble des combinaisons, ou cas de charges, permet de déterminer un hyperplan de dimension réduite par rapport à la dimension de l'espace initial. Une projection sur l'hyperplan de chaque cas de charge de l'ensemble initial de cas de charge, suivi d'une sélection des points formant une enveloppe de la projection sur l'hyperplan permet de constituer un sous-ensemble de points adapté au dimensionnement de la structure.

Ainsi, en référence à la figure 8, le procédé 100 selon l'invention comprend les étapes suivantes pour le dimensionnement d'une structure d'un lanceur spatial LS:
- détermination 101 d'un ensemble des cas de charge à prendre en compte pour dimensionner l'au moins un module M1, M2, M3 du lanceur LS, un cas de charge étant défini comme une combinaison des composantes d'efforts mécaniques qui s'appliquent en même temps à la structure ST1, ST2, ST3 de l'au moins un module M1, M2, M3, chaque combinaison comprenant un nombre N de composantes d'efforts mécaniques, l'ensemble des cas de charge étant ainsi défini dans un espace de dimension N; un effort mécanique est par exemple un effort général et/ou un effort local,
- projection 102 de l'ensemble dans un hyperplan de dimension n, n étant inférieur à N;
- détermination 103 d'une enveloppe de la projection dans l'hyperplan, ladite enveloppe définissant un sous-ensemble de cas de charge ;
- utilisation 104 du sous-ensemble de cas de charge pour dimensionner l'au moins un module M1, M2, M3.

Selon ces dispositions, on obtient un sous-ensemble comprenant un nombre de cas de charge inférieur, voire très inférieur, au nombre de cas de charge de l'ensemble.

En particulier, l'hyperplan est déterminé par une analyse en composantes principales de l'ensemble des cas de charges.

Plus particulièrement, le dimensionnement de la structure comprend la détermination d'une masse du lanceur LS en fonction de critères de dimensionnement ; la détermination d'une masse comprend par exemple la détermination d'une valeur minimum de la masse.

Encore plus particulièrement, la détermination d'une masse du lanceur LS comprend la détermination d'une masse du ou de chacun des modules M1, M2, M3 du lanceur LS, la détermination d'une masse du ou de chacun des modules M1, M2, M3 comprenant la détermination d'une épaisseur d'une sous structure SST de la structure ST1, ST2, ST3 du ou de chacun des modules M1, M2, M3 du lanceur LS..

## Revendications

1. Procédé (100) mis en œuvre par ordinateur pour le dimensionnement d'un lanceur spatial (LS), le lanceur spatial (LS) comprenant au moins un module (M1, M2, M3), l'au moins un module (M1, M2, M3) comprenant une structure (ST1, ST2, ST3), le procédé (100) comprenant les étapes suivantes:
- détermination (101) d'un ensemble des cas de charge à prendre en compte pour dimensionner l'au moins un module (M1, M2, M3) du lanceur (LS), un cas de charge étant défini comme une combinaison des composantes d'efforts mécaniques qui s'appliquent en même temps à la structure (ST1, ST2, ST3) de l'au moins un module (M1, M2, M3), chaque combinaison comprenant un nombre N de composantes d'efforts mécaniques, l'ensemble des cas de charge étant ainsi défini dans un espace de dimension N;
- projection (102) de l'ensemble dans un hyperplan de dimension n, n étant inférieur à N;
- détermination (103) d'une enveloppe de la projection dans l'hyperplan, ladite enveloppe définissant un sous-ensemble de cas de charge ;
- utilisation (104) du sous-ensemble de cas de charge pour dimensionner l'au moins un module (M1, M2, M3).

2. Procédé (100) selon la revendication précédente, l'hyperplan est déterminé par une analyse en composantes principales de l'ensemble des cas de charges.

3. Procédé (100) selon l'une des revendications précédentes, dans lequel un effort mécanique est un effort général et/ou un effort local.

4. Procédé (100) selon l'une des revendications précédentes, dans lequel un effort local est un effort mécanique qui s'applique à une interface (IC1, IC2, IC3) de la structure (ST1, ST2, ST3), ou à une sous-structure (SST) de la structure (ST1, ST2, ST3), de l'au moins un module (M1, M2, M3) du lanceur spatial (LS) avec un composant externe à la structure (ST1, ST2, ST3) de l'au moins un module (M1, M2, M3), l'effort local comprenant au moins une composante (EL1, EL2, EL3, EL4, EL5, EL6, EL7, EL8, EL9) de l'effort local.

5. Procédé (100) selon l'une des revendications précédentes, le composant externe comprend au moins l'un parmi: un ou plusieurs pieds d'atterrissage, un ou plusieurs moteurs (M), une ou plusieurs aérogouvernes.

6. Procédé (100) selon l'une des revendications précédentes, dans lequel le lanceur spatial (LS) comprend au moins deux modules (M1, M2, M3) du lanceur spatial (LS), un effort général étant un effort mécanique qui s'applique à une section d'interface (IS) entre un module (M1, M2, M3) du lanceur spatial (LS) et un autre module (M1, M2, M3) du lanceur spatial (LS), ledit effort général comprenant au moins une composante (M, N, T) de l'effort général.

7. Procédé (100) selon l'une des revendications précédentes, comprenant un dimensionnement de la structure, comprenant une détermination d'une masse du lanceur (LS) en fonction de critères de dimensionnement.

8. Procédé (100) selon la revendication précédente, dans lequel la détermination d'une masse du lanceur (LS) comprend la détermination d'une masse de l'au moins un module (M1, M2, M3) du lanceur (LS), la détermination d'une masse de l'au moins un module (M1, M2, M3) comprenant la détermination d'une épaisseur d'une sous structure (SST) de la structure (ST1, ST2, ST3) de l'au moins un module (M1, M2, M3) en fonction des critères de dimensionnement appliqués à la structure (ST1, ST2, ST3).

## Patentansprüche

1. Computergestütztes Verfahren (100) zur Dimensionierung einer Trägerrakete (LS), wobei die Trägerrakete (LS) mindestens ein Modul (M1, M2, M3) umfasst, wobei das mindestens eine Modul (M1, M2, M3) eine Struktur (ST1, ST2, ST3) umfasst, wobei das Verfahren (100) die folgenden Schritte umfasst:
- Bestimmen (101) einer Gruppe von Lastfällen, die zur Dimensionierung des mindestens einen Moduls (M1, M2, M3) der Trägerrakete (LS) berücksichtigt werden müssen, wobei ein Lastfall als eine Kombination der mechanischen Kraftkomponenten definiert ist, die gleichzeitig auf die Struktur (ST1, ST2, ST3) von mindestens einem Modul (M1, M2, M3) ausgeübt wird, wobei jede Kombination eine Anzahl N von mechanischen Kraftkomponenten umfasst, wobei die Gruppe der Lastfälle in einem Raum der Dimension N definiert ist;
- Projizieren (102) der Gruppe in eine Hyperebene der Dimension n, wobei n kleiner als N ist;
- Bestimmen (103) einer Hüllkurve der Projektion in der Hyperebene, wobei die Hüllkurve eine Untergruppe von Lastfällen definiert;
- Verwenden (104) der Untergruppe von Lastfällen zur Dimensionierung des mindestens einen Moduls (M1, M2, M3).

2. Verfahren (100) nach dem vorhergehenden Anspruch, wobei die Hyperebene durch eine Analyse der Hauptkomponenten der Gruppe der Lastfälle bestimmt wird.

3. Verfahren (100) nach einem der vorhergehenden Ansprüche, wobei eine mechanische Kraft eine allgemeine Kraft und/oder eine lokale Kraft ist.

4. Verfahren (100) nach einem der vorhergehenden Ansprüche, wobei eine lokale Kraft eine mechanische Kraft ist, die auf eine Schnittstelle (IC1, IC2, IC3) der Struktur (ST1, ST2, ST3) oder auf eine Unterstruktur (SST) der Struktur (ST1, ST2, ST3) des mindestens einen Moduls (M1, M2, M3) des Trägerrakete (LS) mit einer Komponente außerhalb der Struktur (ST1, ST2, ST3) des mindestens einen Moduls (M1, M2, M3) ausgeübt wird, wobei die lokale Kraft mindestens eine Komponente (EL1, EL2, EL3, EL4, EL5, EL6, EL7, EL8, EL9) der lokalen Kraft umfasst.

5. Verfahren (100) nach einem der vorhergehenden Ansprüche, wobei die äußere Komponente mindestens eines von Folgendem umfasst: einen oder mehrere Landefüße, einen oder mehrere Motoren (M), ein oder mehrere Ruder.

6. Verfahren (100) nach einem der vorhergehenden Ansprüche, wobei die Trägerrakete (LS) mindestens zwei Module (M1, M2, M3) der Trägerrakete (LS) umfasst, wobei eine allgemeine Kraft eine mechanische Kraft ist, die auf einen Schnittstellenabschnitt (IS) zwischen einem Modul (M1, M2, M3) der Trägerrakete (LS) und einem anderen Modul (M1, M2, M3) der Trägerrakete (LS) ausgeübt wird, wobei die allgemeine Kraft mindestens eine Komponente (M, N, T) der allgemeinen Kraft umfasst.

7. Verfahren (100) nach einem der vorhergehenden Ansprüche, umfassend das Dimensionieren der Struktur, einschließlich des Bestimmens einer Masse der Trägerrakete (LS) in Abhängigkeit von Dimensionierungskriterien.

8. Verfahren (100) nach dem vorhergehenden Anspruch, wobei das Bestimmen einer Masse der Trägerrakete (LS) das Bestimmen einer Masse des mindestens einen Moduls (M1, M2, M3) der Trägerrakete (LS) umfasst, wobei das Bestimmen einer Masse des mindestens einen Moduls (M1, M2, M3) das Bestimmen einer Dicke einer Unterstruktur (SST) der Struktur (ST1, ST2, ST3) des mindestens einen Moduls (M1, M2, M3) in Abhängigkeit von den auf die Struktur (ST1, ST2, ST3) angewandten Dimensionierungskriterien umfasst.

## Claims

1. A computer-implemented method (100) for dimensioning a space launcher (SL), the space launcher (SL) comprising at least one module (M1, M2, M3), the at least one module (M1, M2, M3) comprising a structure (ST1, ST2, ST3), the method (100) comprising the following steps:
- determining (101) a set of load cases to be taken into account for dimensioning the at least one module (M1, M2, M3) of the launcher (SL), a load case being defined as a combination of the mechanical force components that are simultaneously applied to the structure (ST1, ST2, ST3) of the at least one module (M1, M2, M3), each combination comprising a number N of mechanical force components, the set of load cases thus being defined in a space of dimension N;
- projecting (102) the set in a hyperplane of dimension n, n being less than N;
- determining (103) an envelope of the projection in the hyperplane, said envelope defining a subset of load cases;
- using (104) the subset of load cases to dimension the at least one module (M1, M2, M3).

2. The method (100) according to the preceding claim, the hyperplane is determined by a principal component analysis of the set of load cases.

3. The method (100) according to any of the preceding claims, wherein a mechanical force is a general force and/or a local force.

4. The method (100) according to any of the preceding claims, wherein a local force is a mechanical force that is applied to an interface (IC1, IC2, IC3) of the structure (ST1, ST2, ST3), or to a substructure (SST) of the structure (ST1, ST2, ST3), of the at least one module (M1, M2, M3) of the space launcher (LS) with a component external to the structure (ST1, ST2, ST3) of the at least one module (M1, M2, M3), the local force comprising at least one component (EL1, EL2, EL3, EL4, EL5, EL6, EL7, EL8, EL9) of the local force.

5. The method (100) according to any of the preceding claims, the external component comprises at least one of: one or several landing legs, one or several engines (M), one or several aerodynamic control surfaces.

6. The method (100) according to any of the preceding claims, wherein the space launcher (LS) comprises at least two modules (M1, M2, M3) of the space launcher (LS), a general force being a mechanical force that is applied to an interface section (IS) between a module (M1, M2, M3) of the space launcher (LS) and another module (M1, M2, M3) of the space launcher (LS), said general force comprising at least one component (M, N, T) of the general force.

7. The method (100) according to any of the preceding claims, comprising dimensioning of the structure, comprising a determination of a mass of the launcher (LS) based on dimensioning criteria.

8. The method (100) according to the preceding claim, wherein the determination of a mass of the launcher (LS) comprises the determination of a mass of the at least one module (M1, M2, M3) of the launcher (LS), the determination of a mass of the at least one module (M1, M2, M3) comprising the determination of a thickness of a substructure (SST) of the structure (ST1, ST2, ST3) of the at least one module (M1, M2, M3) based on the dimensioning criteria applied to the structure (ST1, ST2, ST3).
